# EUROPEAN PATENT APPLICATION

(11) **EP 2 605 287 A2**
(43) Date of publication of application: **19.06.2013**
(21) Application number: 12185558.9
(22) Date of filing: 21.09.2012
(51) Int. Cl.: H01L 31/0224, H01L 31/068

(54) **Photovoltaic device**

(30) Priority: 13.12.2011 US 201161569956 P; 16.08.2012 US 201213587393
(71) Applicant: Samsung SDI Co., Ltd., Yongin-si, Gyeonggi-do (KR)
(72) Inventor: Seo, Kyoung-Jin, Gyeonggi-do (KR); Jeong, Byong-Gook, Gyeonggi-do (KR); Kim, Hyun-Jong, Gyeonggi-do (KR); Park, Min, Gyeonggi-do (KR); Lee, Czang-Ho, Gyeonggi-do (KR); Lee, Sang-Won, Gyeonggi-do (KR)
(74) Representative: Mounteney, Simon James

(57) **Abstract**

The present invention provides a photovoltaic device comprising:
a substrate (110);
a first (151) and a second electrode (152); and
a gap insulation layer (160) between the two electrodes and on the substrate;

wherein the gap insulation layer comprises a portion (161) that has a higher silicon content to the rest (162) of the gap insulation layer and the portion with the higher silicon content is closer to the substrate.

## Description

### BACKGROUND OF THE INVENTION

### Field of the invention

The present invention relates to a photovoltaic device.

### Description of Related Art

In order to manufacture a photovoltaic device, a p-n junction is formed by doping an n-type (or p-type) dopant into a p-type (or n-type) substrate so as to form an emitter. Pairs of electron-hole formed by receiving light are separated and electrons are collected by an electrode of an n-type area and holes are collected by an electrode of a p-type area, thereby generating electric power.

A photovoltaic device may have a structure in which an electrode is provided at each of a front surface that is a light-receiving surface, and a back surface. When an electrode is provided at the front surface, a light receiving area is decreased as much as an area of the electrode. To address the problem of a decrease in the light receiving area, a back contact structure in which electrodes are provided only on a back surface is used.

### SUMMARY OF THE INVENTION

The present invention provides a photovoltaic device comprising:
a substrate;
a first and a second electrode; and
a gap insulation layer between the two electrodes and on the substrate;
wherein the gap insulation layer comprises a portion that has a higher silicon content to the rest of the gap insulation layer and the portion with the higher silicon content is closer to the substrate.

In a preferred embodiment of the present invention the gap insulation layer comprises a single layer or two layers and when the gap insulation layer comprises two layers, one layer has a higher silicon content than the other layer.

In a preferred embodiment of the present invention the gap insulation layer comprises silicon nitride.

In a preferred embodiment of the present invention the gap insulation layer has the ratio SiₓN_{y} where y is in the range 4.00 to 5.00.

In a preferred embodiment of the present invention one portion of the gap insulation layer has the ratio SiₐN_{b} and the other portion has the ratio Si_{c}N_{d} and the ratio c/d is lower than the ratio a/b. In a preferred embodiment of the present invention the ratio a/b is greater or equal to 0.75.

In a preferred embodiment of the present invention the gap insulation layer comprises two layers and the layer with the higher silicon content is formed directly on the substrate and the other layer is formed directly on the higher silicon content layer.

In a preferred embodiment of the present invention the refractive index of the higher silicon content portion is equal to or greater than 1.98, preferably is equal to or greater than 2.00. In a preferred embodiment of the present invention the refractive index of the lower silicon content portion is less than 1.98, preferably is equal to or less than 1.96.

In a preferred embodiment of the present invention the photovoltaic device further comprises a base region and an emitter region and the gap insulation layer is formed between said base and emitter regions.

The present invention also provides a process for producing the photovoltaic device of all of the embodiments described above comprising:
forming a gap insulation layer on a substrate comprising a portion that has a higher silicon content to the rest of the gap insulation layer and the portion with the higher silicon content is closer to the substrate.

In a preferred embodiment of the present invention the portion with the higher silicon content is formed directly on the substrate and the portion with the lower silicon content is formed directly on the portion with the higher silicon content.

In a preferred embodiment of the present invention the gap insulation layer is formed by plasma enhanced chemical vapour cell deposition.

In a preferred embodiment of the present invention an uneven pattern is formed on the opposite surface of the substrate to the gap insulation layer, preferably the uneven pattern is formed using an alkaline solution.

### BRIEF DESCRIPTION OF THE DRAWINGS

FIG. 1 is a cross-sectional view schematically illustrating a photovoltaic device according to an embodiment of the present invention.
FIG. 2 is a flowchart for explaining a method of manufacturing a photovoltaic device according to an embodiment of the present invention.
FIGS. 3A through 3K are cross-sectional views schematically illustrating a process flow according to the method of FIG. 2.
FIG. 4 is a graph showing an etching amount to an alkaline solution and an etching amount to an acidic solution according to a refractive index of a silicon nitride layer.
FIGS. 5A through 5D are cross-sectional views schematically illustrating a texturing operation of a method of manufacturing a photovoltaic device according to a comparative example of the present invention.
FIG. 6 is a cross-sectional view schematically illustrating a photovoltaic device according to another embodiment of the present invention.

### DETAILED DESCRIPTION OF THE INVENTION

The merits and characteristics of the present invention and a method to achieve the same will be clearly shown with reference to the attached drawings and the below-described embodiments of the present invention. However, the present invention is not limited to the presented embodiments and it will be understood that various changes in form and details may be made therein without departing from the scope of the claims. Embodiments are provided to further completely explain the present invention to one skilled in the art to which the present invention pertains.

The terminology used herein is for the purpose of describing particular embodiments only and is not intended to be limiting of preferred embodiments. As used herein, the singular forms "a/an" and "the" are intended to include the plural forms (a plurality of) as well, unless the context clearly indicates otherwise. It will be further understood that the terms "comprises" and/or "comprising" when used in this specification, specify the presence of stated features, integers, steps, operations, elements, and/or components, but do not preclude the presence or addition of one or more other features, integers, steps, operations, elements, components, and/or groups thereof. The terms such as "first" and "second" are used herein merely to describe a variety of constituent elements, but the constituent elements are not limited by the terms. The terms are used only for the purpose of distinguishing one constituent element from another constituent element.

In the drawings, the thicknesses of layers, regions, and films are exaggerated for clarity. It will also be understood that when a layer is referred to as being "on" another layer or substrate, it can be "directly on" the other layer or substrate, or intervening layers may also be present. Conversely, when a constituent element is described to be "directly on" another constituent element, the constituent element should be construed to be directly connected to another constituent element without any other constituent element interposed therebetween.

By the term "a portion that has a higher silicon content to the rest of the gap insulation layer" it is meant that the gap insulation layer contains a silicon concentration gradient that changes across the thickness of the gap insulation layer. The silicon gradient does not significantly change across the width or length of the gap insulation layer, just the thickness. The silicon gradient increases across the thickness of the gap insulation. In one embodiment this increase may be continuous or discreet. The concentration gradient is such that a portion closer to the substrate has a higher silicon content than the gap insulation layer as a whole.

All numerical references to the figures are included by way of clarification only, the embodiments discussed below are not restricted to the embodiments displayed in the figures unless explicitly recited.

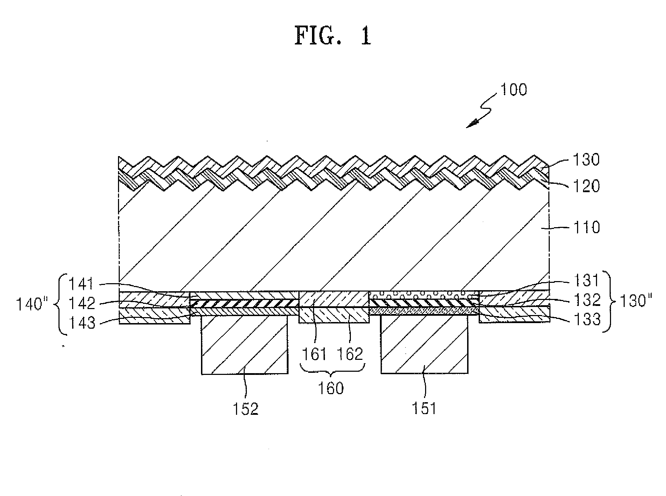

In a preferred embodiment of the present invention as displayed in FIG. 1, the photovoltaic device 100 according to the present embodiment may include a semiconductor substrate 110, a passivation layer 120 and an anti-reflection layer 130 formed on a first surface of the semiconductor substrate 110, a first semiconductor structure 130" of a first conductive type and a second semiconductor structure 140" of a second conductive type which are formed on a back surface of the semiconductor substrate 110, first and second electrodes 151 and 152 respectively formed on the first semiconductor structure 130" of a first conductive type and the second semiconductor structure 140" of a second conductive type, and a gap insulation layer 160 formed between the first and second electrodes 151 and 152. The gap insulation layer 160 may include a first gap insulation layer 161 and a second gap insulation layer 162. The first and second gap insulation layers 161 and 162 may be a silicon nitride layer in which contents of silicon and nitrogen are different from each other.

In an embodiment of the present invention the semiconductor substrate 110 may include a crystal silicon substrate, for example, a monocrystal silicon substrate. The semiconductor substrate 110 preferably may be a monocrystal silicon substrate of an n-type conductive type. Although in the following description the semiconductor substrate 110 is described to be a monocrystal silicon substrate of an n-type conductive type, the present invention is not limited thereto. In another embodiment of the present invention, the semiconductor substrate 110 may preferably be a monocrystal silicon substrate of a p-type conductive type.

The semiconductor substrate 110 preferably may have a first surface and a second surface that is opposite to the first surface. The first surface preferably may be the front surface that is a light-receiving surface and emitter and base electrodes (first and second electrodes 151 and 152) preferably may be provided on the second surface that is the back surface. To increase a light path of incident light and improve the efficiency of absorbing light efficiency, a texture structure including an uneven pattern preferably may be formed on the first surface. The texture structure is an uneven surface including a plurality of minute protrusions and preferably may decrease reflectance of the incident light.

In an embodiment of the present invention the passivation layer 120, if present, is provided on the first surface of the semiconductor substrate 110 and may improve the efficiency of collection of carriers by preventing surface recombination of carriers generated by the semiconductor substrate 110. The passivation layer is preferably directly on the first surface of the substrate. For example, the passivation layer 120 may reduce surface recombination loss due to a defect of a surface of the semiconductor substrate 110 and improve the carrier collection efficiency.

The passivation layer 120 preferably may be an intrinsic semiconductor layer, a doped semiconductor layer, a silicon oxide layer, or a silicon nitride layer. The intrinsic semiconductor layer or the doped semiconductor layer preferably may be formed of amorphous silicon deposited on the semiconductor substrate 110. For example, the passivation layer 120 preferably may be formed of amorphous silicon doped in a first conductive type that is the same as the semiconductor substrate 110. Also, the passivation layer 120 preferably may be doped at a higher concentration than that of the semiconductor substrate 110 so as to form a front surface field (FSF) for preventing the surface recombination.

In an embodiment of the present invention the anti-reflection layer 130 preferably may be formed on the passivation layer 120. The anti-reflection layer 130 prevents light absorption loss due to reflection of light when sunlight is incident. The anti-reflection layer may preferably be formed directly on the passivation layer. The anti-reflection layer 130 preferably may be formed as a silicon oxide layer or a silicon nitride layer. For example, the anti-reflection layer 130 preferably may be formed as a single layer of a silicon oxide layer or a combined layer of a silicon oxide layer and a silicon nitride layer having different refractive indexes.

Although in the present embodiment the passivation layer 120 and the anti-reflection layer 130 are formed as separate layers, the present invention is not limited thereto. In another embodiment, the passivation layer 120 and the anti-reflection layer 130 preferably may be formed as one layer. For example, a silicon nitride layer is formed so that effects of passivation and anti-reflection may be simultaneously obtained.

The first and second semiconductor structures 130" and 140" having the opposite conductive types preferably may be formed on the second surface of the semiconductor substrate 110. The first and second semiconductor structures 130" and 140" respectively form an emitter and a base that separate and collect the carriers generated from the semiconductor substrate 110.

The first semiconductor structure 130" preferably may include a first intrinsic semiconductor layer 131, a first conductive type semiconductor layer 132, and a first transparent conductive layer 133, which are sequentially deposited on the semiconductor substrate 110. The first intrinsic semiconductor layer 131 and the first conductive type semiconductor layer 132 preferably may be formed of amorphous silicon (a-Si) or microcrystal silicon (µ c-Si).

The first intrinsic semiconductor layer 131 preferably may be formed by not doping a dopant or doping a small amount of dopant. For example, the first intrinsic semiconductor layer 131 may passivate a surface of the semiconductor substrate 110 to prevent recombination of the carrier generated from the semiconductor substrate 110, and improve interface characteristics between the semiconductor substrate 110 of crystal silicon and the first conductive type semiconductor substrate 132 of amorphous silicon.

The first conductive type semiconductor layer 132 preferably may be formed by doping a p-type dopant. The first conductive type semiconductor layer 132 preferably may form a p-n junction with the semiconductor substrate 110. The first conductive type semiconductor layer 132 preferably may form an emitter for collecting minority carrier, for example, holes, from the n-type semiconductor substrate 110.

The first transparent conductive layer 133 preferably may include a material that is electrically conductive and optically transparent. For example, the first transparent conductive layer 133 preferably may be formed of transparent conductive oxide (TCO) such as indium tin oxide (ITO) or zinc oxide (ZnO). The first transparent conductive layer 133 may reduce contact resistance with the first electrode 151 and mediate connection between the first conductive type semiconductor layer 132 and the first electrode 151. The first electrode 151 preferably may include silver (Ag), gold (Au), copper (Cu), aluminum (Al), and an alloy thereof.

The second semiconductor structure 140 preferably may include a second intrinsic semiconductor layer 141, a second conductive type semiconductor layer 142, and a second transparent conductive layer 143, which are sequentially deposited on the semiconductor substrate 110. The second intrinsic semiconductor layer 141 and the second conductive type semiconductor layer 142 preferably may be formed of amorphous silicon (a-Si) or microcrystal silicon (µ c-Si).

The second intrinsic semiconductor layer 141 preferably may be formed by not doping a dopant or doping a small amount of dopant. For example, the second intrinsic semiconductor layer 141 may passivate a surface of the semiconductor substrate 110 to prevent recombination of the carrier generated from the semiconductor substrate 110, and improve interface characteristics between the semiconductor substrate 110 of crystal silicon and the second conductive type semiconductor substrate 142 of amorphous silicon.

The second conductive type semiconductor layer 142 preferably may be formed by doping an n-type dopant. The second conductive type semiconductor layer 142 preferably may form a base for collecting minority carrier, for example, electrons, from the n-type semiconductor substrate 110.

The second transparent conductive layer 143 preferably may include a material that is electrically conductive and optically transparent. For example, the second transparent conductive layer 143 preferably may be formed of transparent conductive oxide (TCO) such as indium tin oxide (ITO) or zinc oxide (ZnO). The second transparent conductive layer 143 may reduce contact resistance with the second electrode 152 and mediate connection between the second conductive type semiconductor layer 142 and the second electrode 152. The second electrode 152 preferably may include silver (Ag), gold (Au), copper (Cu), aluminum (Al), and an alloy thereof.

Although in the present embodiment the first and second semiconductor structures 130" and 140" forming an emitter and a base are described to respectively include the first and second intrinsic semiconductor layers 131 and 141, the first and second conductive type semiconductor layers 132 and 142, and the first and second transparent conductive layers 133 and 143, the present invention is not limited thereto. In another embodiment of the present invention, the first and second semiconductor structures 130" and 140" preferably may not include the first and second intrinsic semiconductor layers 131 and 141. Also, in another embodiment of the present invention, the first and second semiconductor structures 130" and 140" preferably may not include the first and second transparent conductive layers 133 and 143.

In an embodiment of the present invention the gap insulation layer 160 is preferably provided between the emitter and the base and preferably includes the first and second gap insulation layers 161 and 612. In a preferred embodiment of the present invention the first gap insulation layer comprises from 65% to 85%, preferably from 70% to 80% of the total thickness of the gap insulation layer. In a preferred embodiment of the present invention the second gap insulation layer comprises from 15% to 35%, preferably from 20% to 30% of the total thickness of the gap insulation layer.

In a preferred embodiment of the present invention the gap insulation layer is between about 600 and 1000 Å thick, preferably about 700 and 900 Å, more preferably about 800 Å.

In a preferred embodiment of the present invention the first gap insulation layer (high-silicon content layer) is between about 450 and 750 Å thick, preferably about 550 and 600 Å, more preferably about 600 Å. In a preferred embodiment of the present invention the second gap insulation layer (low-silicon content layer) is between about 100 and 300 Å thick, preferably about 150 and 250 Å, more preferably about 200 Å.

In an embodiment of the present invention the first gap insulation layer 161 preferably may be formed on a second surface of the semiconductor substrate 110. The second gap insulation layer 162 preferably may be formed directly on the first gap insulation layer 161. In a preferred embodiment the gap insulation layer comprises two layers and the first gap insulation layer is formed directly on the substrate and the second gap insulation layer is formed directly on the first gap insulation layer.

In an embodiment of the present invention the first and second gap insulation layers 161 and 162 preferably comprises silicon nitride, preferably hydrogenated silicon nitride. In a preferred embodiment both layers 161 and 162 comprise silicon nitride, preferably hydrogenated silicon nitride. In a preferred embodiment the layers consist essentially of one compound each, preferably that compound is silicon nitride, more preferably hydrogenated silicon nitride. Preferably, the gap insulation layer comprises a silicon nitride that has the composition ratio of silicon to nitrogen SiₓN_{y}, where y is in the range 3.90 to 5.20, preferably 4.00 to 5.00. In a preferred embodiment of the present invention, the gap insulation comprises hydrogenated silicon nitride that has the composition ratio of silicon to nitrogen SiₓN_{y}H_{z} where y is in the range 3.90 to 5.20, preferably 4.00 to 5.00. In a preferred embodiment of the present invention, in either ratio discussed above, x may take be within the range 2.50 to 4.20, preferably 2.70 to 3.90. In a preferred embodiment of the present invention, in any of the embodiments discussed above, z, when present, may be within the range 1.00 to 3.20, preferably 1.00 to 2.50.

In a preferred embodiment when the gap insulation layer comprises two layers and both are silicon nitride, preferably hydrogenated silicon nitride, with a composition ratio (a:b) of silicon (Si) and nitrogen (N) forming the first gap insulation layer (i.e. with a ratio SiₐN_{b}) 161 is different from a composition ratio (c:d) of silicon and nitrogen forming the second gap insulation layer (i.e. with a ratio Si_{c}N_{d}) 162.In this embodiment, the first gap insulation layer (with a ratio SiₐN_{b}) 161 is a silicon nitride layer preferably having a relatively higher silicon content than that of the second gap insulation layer 162. The second gap insulation layer (with a ratio Si_{c}N_{d}) 162 is a silicon nitride layer preferably having a relatively higher nitrogen content than that of the first gap insulation layer 161. In detail, the first gap insulation layer 161 preferably has a higher silicon content than that of a stoichiometric silicon nitride layer (Si₃N₄). The second gap insulation layer 162 preferably has a higher nitrogen content than that of a stoichiometric silicon nitride layer (Si₃N₄). In other words, the composition ratio (a/b) of the first gap insulation layer 161 is preferably equal to or greater than 0.75 (=3/4) that is the composition ratio (Si/N) of silicon and nitrogen of the stoichiometric silicon nitride layer, preferably, the ratio a/b may take values within the range 0.75 to 0.90, more preferably 0.80 to 0.85.

The composition ratio (c/d) of the second gap insulation layer 162 is preferably smaller than 0.75 that is the composition ratio (Si/N) of silicon and nitrogen of the stoichiometric silicon nitride layer, preferably, the ratio c/d may take values within the range 0.50 to 0.70, more preferably 0.55 to 0.65.

The content of silicon is a factor that affects refractive index. As the content of silicon increases in a silicon nitride layer, a refractive index increases. The refractive index of the first gap insulation layer 161 preferably may be equal to or greater than about 1.98, preferably is equal to or greater than 2.00. Preferably, the maximum refractive index for the first gap insulation layer is 2.75, more preferably 2.60. The refractive index of the second gap insulation layer 162 preferably may be less than 1.98, preferably is equal to or less than 1.96. Preferably, the minimum refractive index for the second gap insulation layer is 1.80, more preferably 1.85

The present invention also provides a method of manufacturing the above described photovoltaic devices comprising:
forming a gap insulation layer on a substrate, comprising a portion that has a higher silicon content to the rest of the layer and the portion with the higher silicon content is closer to the substrate.

In a preferred embodiment of the present invention the portion with the higher silicon content is formed directly on the substrate and the portion with the lower silicon content is formed directly on the portion with the higher silicon content.

In a preferred embodiment of the present invention the gap insulation layer is formed by plasma enhanced chemical vapour cell deposition.

In a preferred embodiment of the present invention an uneven pattern is formed on the opposite surface of the substrate to the gap insulation layer, preferably the uneven pattern is formed using an alkaline solution.

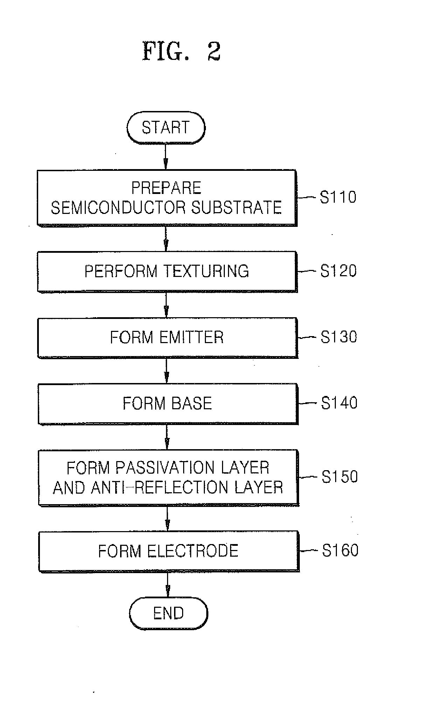

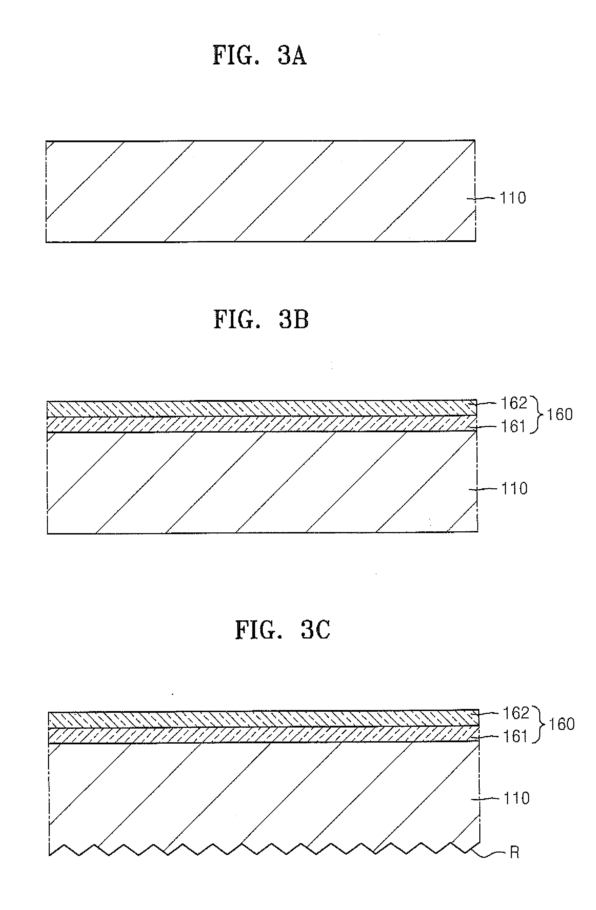

A preferred method of manufacturing a photovoltaic device according to an embodiment of the present invention will now be described with reference to FIGS. 2 and 3A through 3K.

FIG. 2 is a flowchart for explaining a preferred method of manufacturing a photovoltaic device according to an embodiment of the present invention. FIGS. 3A through 3K are cross-sectional views schematically illustrating a process flow of the method of FIG. 2.

In S110, the semiconductor substrate 110 is prepared (see FIG. 3A). The semiconductor substrate 110 preferably may be a monocrystal silicon substrate. The semiconductor substrate 110 preferably may have n-type (or p-type) conductivity.

Referring to FIG. 3B, in a preferred embodiment of the present invention the gap insulation layer comprises a silicon nitride layer 160 which is formed on the second surface of the semiconductor substrate 110. The silicon nitride layer 160 preferably includes the first and second silicon nitride layers 161 and 162. Here, the composition ratio (a:b) of silicon (Si) and nitrogen (N) forming the first silicon nitride layer (with a ratio SiₐN_{b}) 161 is different from a composition ratio (c:d) of silicon and nitrogen forming the second silicon nitride layer (with a ratio Si_{c}N_{d}) 162.

Preferably, as discussed above, the first silicon nitride layer (with a ratio SiₐN_{b}) 161 has a relatively higher silicon content than that of the second silicon nitride layer 162. The second silicon nitride layer (with a ratio Si_{c}N_{d}) 162 has a relatively higher nitrogen content than that of the first silicon nitride layer 161.

The first and second silicon nitride layers 161 and 162 preferably may be formed by a plasma enhanced chemical vapor deposition (PE-CVD) method. During PE-CVD, The contents of nitrogen (N) and silicon (Si) may be adjusted. For example, the first and second silicon nitride layers 161 and 162 may be formed by adjusting flow rates of a gas that is a supply source of silicon and a gas that is a supply source of nitrogen.

In a preferred embodiment of the present invention, gap insulation layer is formed by supplying SiH₄, NH₃, and N₂ into a PE-CVD chamber at the same time.

In a preferred embodiment of the present invention, the relatively Si-rich layer is formed by supplying the gases of SiH₄, NH₃, and N₂ at a ratio of between 1.5:3:35 and 2.5:3:35 (sccm - Standard Cubic Centimeters per Minute), more preferably 2:3:35 (sccm). In an embodiment of the present invention, the above-mentioned gases are supplied between about 40 and 80 seconds, preferably between about 50 and 70 seconds, most preferably for about 60 seconds.

In a preferred embodiment of the present invention, the relatively N-rich layer is formed by supplying the gases of SiH₄, NH₃, and N₂ at a ratio of between 0.5:3:35 and 1.5:3:35 (sccm), more preferably 1:3:35 (sccm). In an embodiment of the present invention, the above-mentioned gases are supplied between about 5 and 30 seconds, preferably between about 10 and 25 seconds, most preferably for about 20 seconds.

In an embodiment of the present invention, the formation an interface between the Si-rich layer and the N-rich layer vary according to whether it takes a long time or a short time to switch from the Si-rich layer forming process to the N-rich layer forming process. That is, if switching from the Si-rich layer forming process to the N-rich layer forming process is slow, there may be no interface therebetween, and, if switching from the Si-rich layer forming process to the N-rich layer forming process is fast, an interface may occur therebetween.

In an embodiment of the present invention, preferably the switch between the initial and final feed rates discussed above occurs over a time period of between 0 and 30 seconds. In an embodiment of the present invention the fast switch preferably occurs in the range of 0 to 10 seconds, preferably between 0 and 5 seconds, preferably 0 seconds. A switch time of 0 seconds means the flow is stopped, the flow rate is then adjusted and then the flow restarts at the new flow rate. In an embodiment of the present invention the slow switch preferably occurs in the range of 15 to 30 seconds, preferably between 20 and 25 seconds.

In S120, a texturing process of forming an uneven pattern R on the first surface of the semiconductor substrate 110 is performed. This is preferably formed using an alkaline solution as known in the art,.

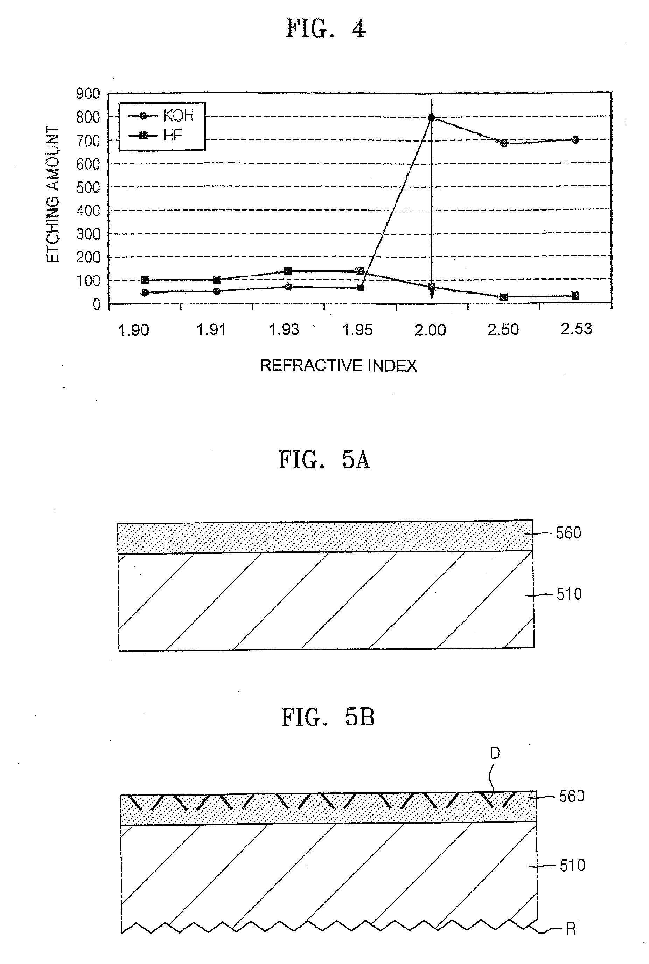

Referring to FIG. 3C, the uneven pattern R is formed on the first surface of the semiconductor substrate 110 using the silicon nitride layer 160, when present, the second silicon nitride layer 162, as a mask. Referring to FIG. 4, in preferred embodiments of the present invention, the second silicon nitride layer 162 has a high nitrogen content and characteristically has strong resistance to an alkaline solution. The second silicon nitride layer 162 formed on the top layer functions as an etch mask during texturing for forming the uneven pattern R on the surface of the semiconductor substrate 110. An alkaline solution such as KOH, NaOH, or tetramethylammonium (TMAH) preferably may be used as a texturing etchant.

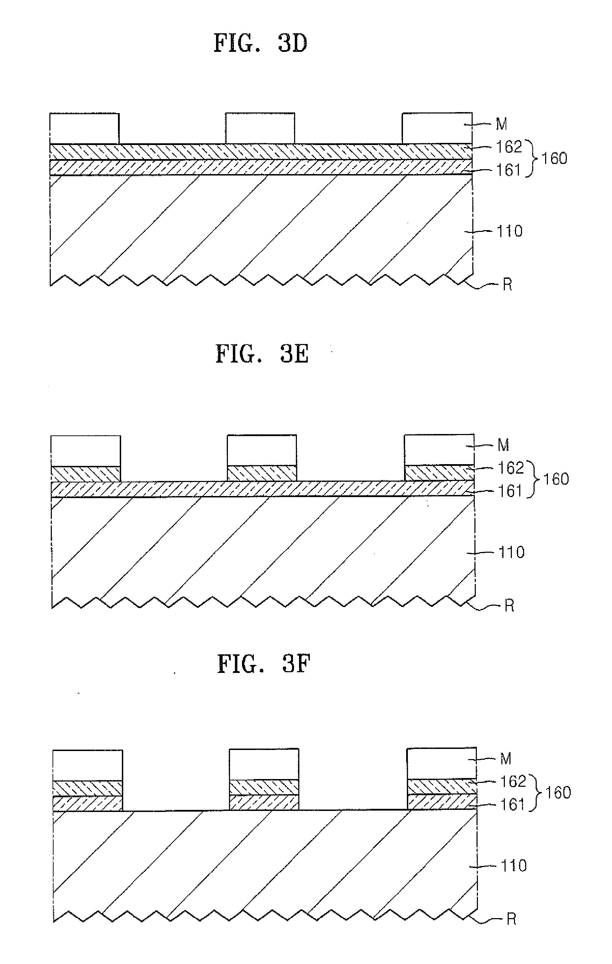

Referring to FIG. 3D, an anti-etching layer M is preferably formed on the second silicon nitride layer 162. The anti-etching layer M preferably may be an organic layer. The anti-etching layer M preferably may be formed on the second silicon nitride layer 162 to cover an area of the second silicon nitride layer 162 except for an area where an emitter and a base, which will be described later, are to be formed.

Referring to FIG. 3E, the second silicon nitride layer 162 is etched using the anti-etching layer M as a mask. The second silicon nitride layer 162 having a high nitrogen content and strong resistance to an alkaline solution but weak resistance to an acidic solution, as described above. Accordingly, to etch the second silicon nitride layer that is not protected by the anti-etching layer, an acidic solution such as hydrofluoric acid (HF) or nitric acid (HNO₃) is preferably used as an etchant. In doing so, the first silicon nitride layer 161 disposed under the second silicon nitride layer 162 is not be damaged because it has strong resistance to an acidic solution.

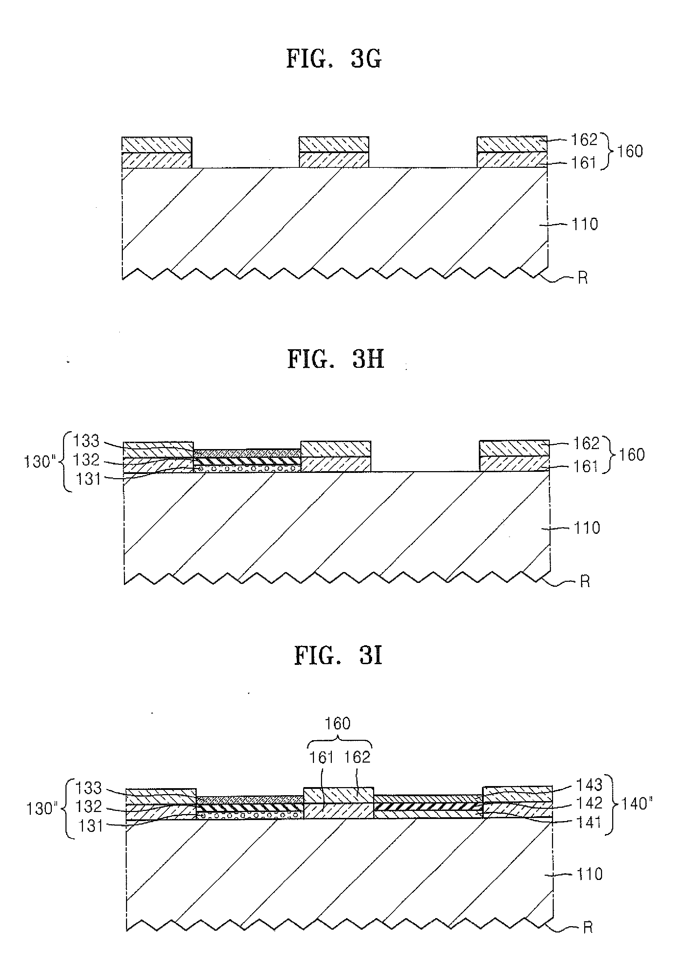

Referring to FIG. 3F, the first silicon nitride layer 161 is etched using the anti-etching layer M as a mask. The etchant etches the first silicon nitride layer 161. For example, the etchant preferably may be a mixed solution of hydrofluoric acid (HF), nitric acid (HNO₃), and acetic acid. Alternatively, the etchant preferably may be a mixed solution of hydrofluoric acid (HF), nitric acid (HNO₃), and deionized water (DIW). As the first silicon nitride layer 161 has relatively strong resistance to acid, an area of the first silicon nitride layer 161 that is not protected by the anti-etching layer M may be selectively removed by adopting sufficient concentration and time for removing the first silicon nitride layer 161 Referring to FIG. 3G, the anti-etching layer M is removed. The anti-etching layer M preferably may be removed by using an ethanol or acetone based solution.

According to the above-described operations, when the first and second silicon nitride layers 161 and 162 are removed by using the anti-etching layer M as a mask, a partial area of the second surface of the semiconductor substrate 110 is exposed. In an operation that will be described later, an emitter region and a base region preferably may be formed on a first area and a second area of the partial area of the second surface of the semiconductor substrate 110, respectively. The first and second silicon nitride layers 161 and 162 disposed between the emitter region and the base region may become a gap insulation layer.

In S130, the first semiconductor structure 130" is formed in the first region of the second surface of the semiconductor substrate 110.

Referring to FIG. 3H, the first semiconductor structure 130" is formed on the first area of the second surface of the semiconductor substrate 110. The first semiconductor structure 130" preferably may include the first intrinsic semiconductor layer 131, the first conductive type semiconductor layer 132, and the first transparent conductive layer 133.

The first intrinsic semiconductor layer 131 and the first conductive type semiconductor layer 132 preferably may include amorphous silicon (a-Si) or microcrystal silicon (µ c-Si). The first transparent conductive layer 133 preferably may include a material that is electrically conductive and optically transparent.

As a non-restrictive method of the present invention, first intrinsic semiconductor layer 131 and the first conductive type semiconductor layer 132 preferably may be formed by applying a CVD method in a state in which the second region of the second surface of the semiconductor substrate 110 is protected by a mask (not shown). The first transparent conductive layer 133 preferably may be formed by a method such as sputtering, e-beam, evaporation, etc.

In S140, the second semiconductor structure 140" is formed in the second region of the second surface of the semiconductor substrate 110.

Referring to FIG. 3I, the second semiconductor structure 140" is formed in the second region of the second surface of the semiconductor substrate 110. The second semiconductor structure 140" preferably may include the second intrinsic semiconductor layer 141, the second conductive type semiconductor layer 142, and the second transparent conductive layer 143.

The second intrinsic semiconductor layer 141 and the second conductive type semiconductor layer 142 preferably may include amorphous silicon (a-Si) or microcrystal silicon (µ c-Si). The second transparent conductive layer 143 preferably may include a material that is electrically conductive and optically transparent.

As a non-restrictive method of the present invention, although in the present embodiment the first and second semiconductor substrates 130" and 140" are described to include the first and second intrinsic semiconductor layers 131 and 141, the first and second conductive type semiconductor layers 132 and 142, and the first and second transparent conductive layers 133 and 143, the present invention is not limited thereto. In another embodiment of the present invention, the first and second semiconductor substrates 130" and 140" preferably may not include the first and second intrinsic semiconductor layers 131 and 141. Alternatively, in another embodiment of the present invention, the first and second semiconductor substrates 130" and 140" preferably may not include the first and second transparent conductive layers 133 and 143.

In S150, the passivation layer 120 and the anti-reflection layer 130 are formed. Prior to the formation of the passivation layer 120 and the anti-reflection layer 130, the semiconductor substrate 110 preferably may be cleaned for effective passivation.

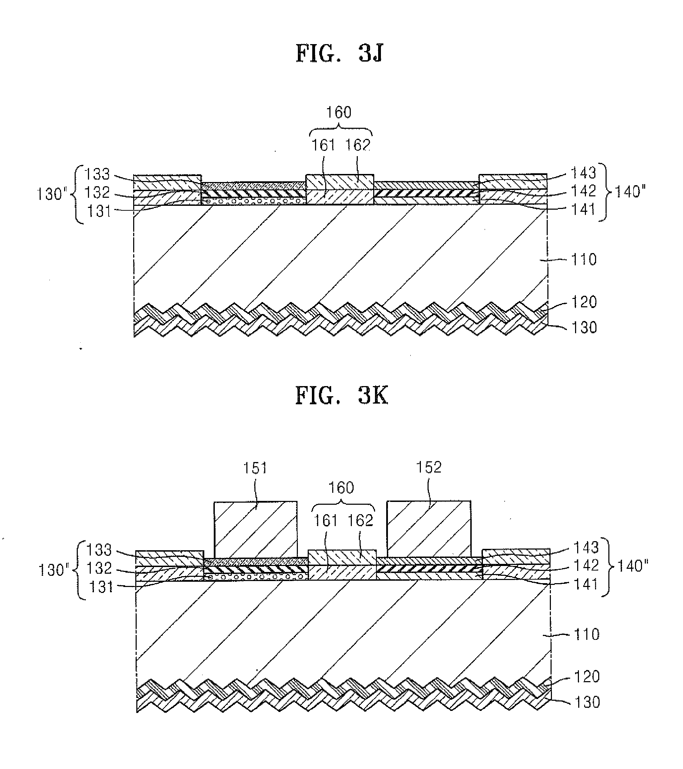

Referring to FIG. 3J, the passivation layer 120 and the anti-reflection layer 130 preferably may be formed on the first surface of the semiconductor substrate 110.

The passivation layer 120 preferably may be formed by a CVD method, for example, a CVD method using silane (SiH₄) that is a silicon containing gas. Since the passivation layer 120 is formed on the first surface, that is, a light-receiving surface, of the semiconductor substrate 110, a band gap preferably may be adjusted to reduce light absorption. For example, the band gap is increased by adding an additive so that light absorption may be reduced and thus incident light may be absorbed in the semiconductor substrate 110.

The anti-reflection layer 130 preferably may be formed as a silicon oxide layer or a silicon nitride layer. For example, the anti-reflection layer 130 preferably may be formed as a single layer of a silicon oxide layer or a combination layer of a silicon oxide layer and a silicon nitride layer having different refractive indexed. The anti-reflection layer 130 preferably may be formed by a CVD method, sputtering, spin coating, etc.

Although in the present embodiment the passivation layer 120 and the anti-reflection layer 130 are described to be formed as separated layers, the present invention is not limited thereto. In another embodiment of the present invention, a silicon nitride layer capable of simultaneously performing functions of the passivation layer 120 and the anti-reflection layer 130 preferably may be formed.

In S160, the first and second electrodes 151 and 152 are formed.

Referring to FIG. 3K, the first and second electrodes 151 and 152 are respectively formed on the first and second semiconductor structures 130" and 140". For example, the first and second electrodes 151 and 152 preferably may be formed by coating paste including silver (Ag), copper (Cu), aluminum (Al), and an alloy thereof and then firing the same. In another embodiment, the first and second electrodes 151 and 152 preferably may be formed by performing a method such as electroplating after an electrode seed (not shown) is formed.

According to the method of manufacturing a photovoltaic device described with reference to FIGS. 2 and 3A through 3K, a silicon nitride layer includes the first and second silicon nitride layers 161 and 162 having different compositions. Texturing is performed by using the silicon nitride layer 162, and a partial area of the silicon nitride layers 161 and 162 is removed by selective etching so that a high quality gap insulation layer 160 is formed. (see FIG. 1) The above-described characteristic of the present invention will be clearly disclosed through the explanation of a method of manufacturing a photovoltaic device according to a comparative example that is described below.

FIGS. 5A through 5D are cross-sectional views schematically illustrating a texturing operation of a method of manufacturing a photovoltaic device according to a comparative example of the present invention.

While the silicon nitride layer 160 according to the present invention includes the first and second portions having differing silicon contents, preferably, silicon nitride layers 161 and 162 having different compositions, according to a comparative example of the present invention is a silicon nitride layer 560having a composition of Si₃N₄ throughout, i.e. there is not a significant silicon concentration gradient across the thickness of the gap insulation layer.

Referring to FIG. 5A, the silicon nitride layer 560 having a composition of Si₃N₄ is formed on a semiconductor substrate 510. The silicon nitride layer 560 is formed on a second surface, that is, a back side of a light-receiving surface, of the semiconductor substrate 510.

Referring to FIG. 5B, an uneven pattern R' is formed on a first surface of the semiconductor substrate 510 using the silicon nitride layer 560 as a mask. An alkaline solution such as KOH, NaOH, or tetramethylammonium (TMAH) preferably may be used as a texturing etchant.

Although the silicon nitride layer 560 having a composition of Si₃N₄ according to the comparative example of the present invention protects the second surface of the semiconductor substrate 510 to a degree, the silicon nitride layer 560 itself is damaged by the alkaline solution so that a damage D may be generated.

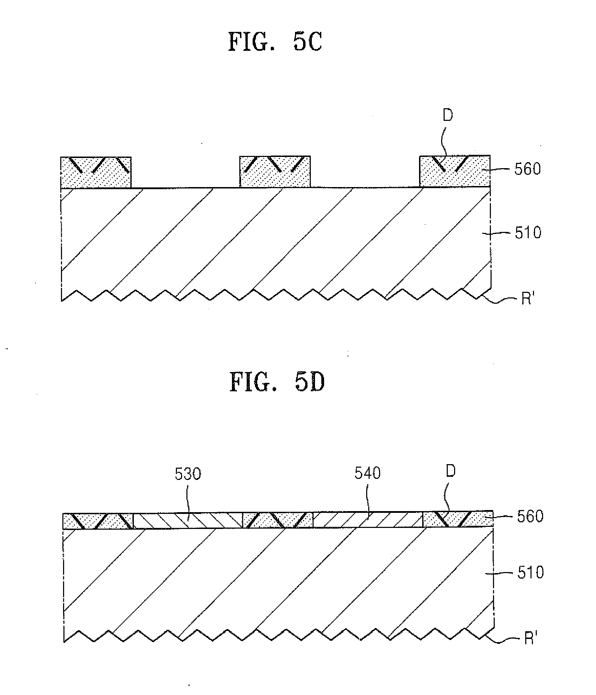

Referring to FIGS. 5C and 5D, after an anti-etching layer (not shown) is formed on the silicon nitride layer 560 and a part of the silicon nitride layer 560 is etched, the first and second semiconductor structures 530 and 540 preferably may be formed in the emitter and base regions, respectively.

According to the method of manufacturing a photovoltaic device according to the comparative example, since the damage D is generated in the silicon nitride layer 560, the function of the gap insulation layer 560 between the first and second semiconductor substrates 530 and 540, for example, the passivation function of the semiconductor substrate 510, is difficult to maintain due to the damage D so that a characteristic of the photovoltaic device may be deteriorated.

However, compared to the silicon nitride layer 560 according to the comparative example, the portion that has a lower silicon content, preferably the second silicon nitride layer 162, that is the top portion of the gap insulation layer 160 according to the present invention has superior resistance to an alkaline solution, so that no damage may be generated.

In the meantime, to remove the damage D from the silicon nitride layer 560, that is, the gap insulation layer, of the photovoltaic device according to the above-described comparative example, a process of removing the silicon nitride layer 560 and then forming a new insulation layer is provided after the uneven pattern R' is formed on the first surface of the semiconductor substrate 510 and before the process of FIG. 5C is performed. However since no damage is generated in the silicon nitride layer 160, that is, the insulation layer of the photovoltaic device according to the present invention, the above-described process is not needed.

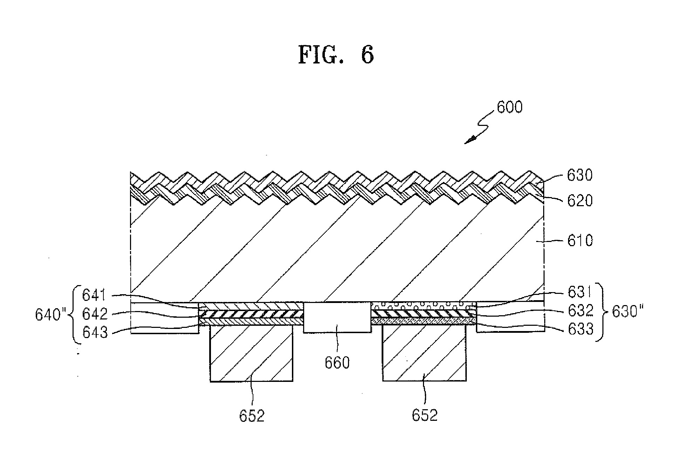

FIG. 6 is a cross-sectional view schematically illustrating a photovoltaic device 600 according to another embodiment of the present invention.

Referring to FIG. 6, the photovoltaic device 600 according to the present embodiment preferably may include a semiconductor substrate 610, a passivation layer 620 and an anti-reflection layer 630 formed on a first surface of the semiconductor substrate 610, a first semiconductor structure 630" of a first conductive type and a second semiconductor structure 640" of a second conductive type which are formed on a back surface of the semiconductor substrate 610, first and second electrodes 651 and 652 respectively formed on the first and second semiconductor structures 630 and 640, and a gap insulation layer 660 formed between the first and second semiconductor structures 630 and 640.

However, the photovoltaic device 600 of the present embodiment is different from the photovoltaic device 100 of FIG. 1 in that a silicon nitride layer that is the gap insulation layer 660 is formed as a single layer, i.e. the portions with differing silicon contents are not separated by a distinct boundary or interface. In this embodiment of the present invention the silicon concentration gradient across the thickness of the gap insulation layer may preferably increase continuously.

In a preferred embodiment, a lower area of the gap insulation layer 660, that is, an area close to the semiconductor substrate 610, has substantially the same composition as that of the first gap insulation layer 161 described above, i.e. preferably the lower area has a composition SiₐN_{b}. Also, an upper area of the gap insulation layer 660, that is, an area far from the semiconductor substrate 610, has substantially the same composition as that of the second gap insulation layer 162 described with above i.e. preferably the lower area has a composition Si_{c}N_{d}. Preferably, the structure of the photovoltaic device 600 of the present embodiment is substantially the same as that of the photovoltaic device 100 of FIG. 1. The photovoltaic device 600 of the present embodiment preferably may be manufactured through substantially the same operations as those of the manufacturing method described with reference to FIGS. 2 and 3C through 3K.

In the photovoltaic device 100 of FIG. 1 and the photovoltaic device 600 of FIG. 6, the interfaces of the gap insulation layers 160 and 660 may be controlled by a process of forming a silicon nitride layer on the second surfaces of the semiconductor substrates 110 and 610. For example, the existence of interface may be controlled by adjusting a flow rate of a gas that is a supply source of silicon and a gas that is a supply source of nitrogen, and a condition such as time for performing PE-CVD.

While this invention has been particularly shown and described with reference to embodiments thereof, it will be understood by those skilled in the art that various changes in form and details may be made therein without departing from the scope of the invention as defined by the appended claims.

## Claims

1. A photovoltaic device comprising:
a substrate;
a first and a second electrode; and
a gap insulation layer between the two electrodes and on the substrate;
wherein the gap insulation layer comprises a portion that has a higher silicon content to the rest of the gap insulation layer and the portion with the higher silicon content is closer to the substrate.

2. The photovoltaic device of claim 1, wherein the gap insulation layer comprises a single layer or two layers and when the gap insulation layer comprises two layers one layer has a higher silicon content than the other layer.

3. The photovoltaic device of claim 1 or claim 2, wherein the gap insulation layer comprises silicon nitride.

4. The photovoltaic device of claim 3, wherein the gap insulation layer has the ratio SiₓN_{y} where y is in the range 4.00 to 5.00.

5. The photovoltaic device of claim 3 or 4, wherein one portion has the ratio SiₐN_{b} and the other portion has the ratio Si_{c}N_{d} and the ratio c/d is lower than the ratio a/b.

6. The photovoltaic device of any of claim 5, wherein the ratio a/b is greater or equal to 0.75.

7. The photovoltaic device of any of claims 2 to 6, wherein the gap insulation layer comprises two layers and the layer with the higher silicon content is formed directly on the substrate and the other layer is formed directly on the higher silicon content layer.

8. The photovoltaic device of any of claims 1 to 7, wherein the refractive index of the higher silicon content portion is equal to or greater than 1.98, preferably is equal to or greater than 2.00.

9. The photovoltaic device of any of claims 1 to 8, wherein the refractive index of the lower silicon content portion is less than 1.98, preferably is equal to or less than 1.96.

10. The photovoltaic device of any of claims 1 to 9, wherein the photovoltaic device further comprises a base region and an emitter region and the gap insulation layer is formed between said base and emitter regions.

11. A process for producing the photovoltaic device of any of claims 1 to 10, comprising:
forming a gap insulation layer on a substrate, wherein the gap insulation comprises a portion that has a higher silicon content to the rest of the layer and the portion with the higher silicon content is closer to the substrate.

12. The process of claim 11, wherein the portion with the higher silicon content is formed directly on the substrate and the portion with the lower silicon content is formed directly on the portion with the higher silicon content.

13. The process of claim 11 or 12, wherein the gap insulation layer is formed by plasma enhanced chemical vapour cell deposition.

14. The process of any of claims 11 to 13, wherein an uneven pattern is formed on the opposite surface of the substrate to the gap insulation layer, preferably the uneven pattern is formed using an alkaline solution.
